# EUROPEAN PATENT APPLICATION

(11) **EP 4 800 571 A1**
(43) Date of publication of application: **02.09.2026**
(21) Application number: 25225547.6
(22) Date of filing: 19.12.2025
(51) Int. Cl.: G06F 16/3329, G06F 30/17, G06F 30/27

(54) **SYSTEM AND METHOD FOR DESIGN AND OPTIMIZATION OF INDUSTRIAL ENTITY**

(30) Priority: 27.02.2025 IN 202521017373
(71) Applicant: Tata Consultancy Services Limited, Mumbai, Maharashtra 400 021 (IN)
(72) Inventor: JADHAV, Vishal Sudam, 411057 Pune (IN); MISHRA, Sandeep, 411057 Pune (IN); KARANDE, Shirish, 411006 Pune (IN); RUNKANA, Venkataramana, 411028 Pune (IN)
(74) Representative: Goddar, Heinz J.

(57) **Abstract**

Existing design methods rely on manual effort, trial-and-error approaches, and simplified models, which can lead to suboptimal designs and reduced efficiency. The present disclosure obtains a first set of responses for a first set of questions from a user and generates a second set of questions. A second set of responses is obtained and one or more questions specific to a problem formulation are generated using one or more autonomous programs. A first set of data corresponding to one or more questions is retrieved from a knowledge base and one or more gaps is identified. A second set of data is retrieved from one or more resources and knowledge base is updated. One or more process models and corresponding one or more optimization models are retrieved, and a relevant process model is selected. The most appropriate one or more optimization models are selected and, and feedback is obtained from user.

## Description

### CROSS-REFERENCE TO RELATED APPLICATIONS AND PRIORITY

The present application claims priority to Indian application no. 202521017373, filed on February 27, 2025.

### TECHNICAL FIELD

The disclosure herein generally relates to design and optimization, and, more particularly, to a system and method for design and optimization of industrial entity.

### BACKGROUND

The design and optimization of an industrial equipment typically involve first-principle mathematical modeling, followed by optimization to achieve optimal design. While computer programs are commonly used to solve mathematical models and optimization problems, they often require customization to meet specific design requirements.

Mathematical modeling and optimization of industrial entities require a diverse group of human experts, including scientists, engineers, developers, and operational managers, to function effectively, thereby increasing complexity and creating a bottleneck in terms of expertise and resource availability. Currently modelling of industrial entities relies on licensed and commercial tools which necessitates the development of expertise in these tools, adding to the overall cost and limiting flexibility and adaptability. Further the current modeling and optimization system does not allow for customization of optimization algorithms, restricting exploration and experimentation of possible optimal scenarios.

The industrial entity's design is based on outdated methodologies, which are not aligned with state-of-the-art (SOTA) methods, resulting in suboptimal performance and limited innovation. Existing system does not provide visibility into algorithm design methods used, making it challenging to understand and improve the system's performance. Further, the existing system does not provide control over the methods used, making it difficult to design and implement new algorithms.

The existing system's inability to effectively utilize SOTA methods results in wasted time and resources, as developing and implementing new SOTA methods requires significant expertise and time. These problems collectively hinder the system's performance, scalability, and innovation, highlighting the need for a more efficient and effective solution.

### SUMMARY

Embodiments of the present disclosure present technological improvements as solutions to one or more of the above-mentioned technical problems recognized by the inventors in conventional systems. For example, in one embodiment, a method for design and optimization of industrial entity is provided. The method includes obtaining, via one or more hardware processors, a first set of responses for a first set of questions from a user, wherein the first set of questions comprise one or more requirements specific to a design of an industrial entity; generating, via the one or more hardware processors, a second set of questions using one or more Large Language Models (LLMs) by refining the first set of questions based on the first set of responses; obtaining, via the one or more hardware processors, a second set of responses for the second set of questions from the user; generating, via the one or more hardware processors, using one or more autonomous programs, one or more queries specific to a problem formulation comprising one or more sub problem formulations based on the second set of responses, wherein the one or more autonomous programs refer to one or more entities that perform at least one of one or more specific tasks or one or more operations; retrieving, via the one or more hardware processors, a first set of data corresponding to the one or more queries specific to the problem formulation from a knowledge base, by interacting with the knowledge base using the one or more autonomous programs; identifying, via the one or more hardware processors, missing data from the first set of data corresponding to the one or more queries specific to the problem formulation as one or more gaps; retrieving, via the one or more hardware processors, a second set of data from one or more accessible resources based on the identified one or more gaps; updating, via the one or more hardware processors, the knowledge base with the retrieved second set of data; and iteratively performing, via the one or more hardware processors, the following steps until the one or more requirements specific to the design of the industrial entity from the user is satisfied: retrieving at least one of one or more process models and corresponding one or more optimization models based on the second set of data updated in the knowledge base; selecting at least one relevant process model amongst the retrieved one or more process models based on the one or more queries specific to the problem formulation; evaluating at least one of the retrieved one or more optimization models corresponding to the selected relevant process model; selecting at least one relevant optimization model amongst the evaluated one or more optimization models; and obtaining feedback from the user based on the selection.

In another aspect, there is provided a system for design and optimization of industrial entity. The system comprises: a memory storing instructions; one or more communication interfaces; and one or more hardware processors coupled to the memory via the one or more communication interfaces, wherein the one or more hardware processors are configured by the instructions to: obtain a first set of responses for a first set of questions from a user, wherein the first set of questions comprise one or more requirements specific to a design of an industrial entity. The system further includes generating a second set of questions using one or more Large Language Models (LLMs) by refining the first set of questions based on the first set of responses; obtaining a second set of responses for the second set of questions from the user; generating, using one or more autonomous programs, one or more queries specific to a problem formulation comprising one or more sub problem formulations based on the second set of responses, wherein the one or more autonomous programs refer to one or more entities that perform at least one of one or more specific tasks or one or more operations; retrieving a first set of data corresponding to the one or more queries specific to the problem formulation from a knowledge base, by interacting with the knowledge base using the one or more autonomous programs; identifying missing data from the first set of data corresponding to the one or more queries specific to the problem formulation as one or more gaps; retrieving a second set of data from one or more accessible resources based on the identified one or more gaps; updating the knowledge base with the retrieved second set of data; and iteratively performing the following steps until the one or more requirements specific to the design of the industrial entity from the user is satisfied: retrieving at least one of one or more process models and corresponding one or more optimization models based on the second set of data updated in the knowledge base; selecting at least one relevant process model amongst the retrieved one or more process models based on the one or more queries specific to the problem formulation; evaluating at least one of the retrieved one or more optimization models corresponding to the selected relevant process model; selecting at least one relevant optimization model amongst the evaluated one or more optimization models; and obtaining feedback from the user based on the selection.

In yet another aspect, there are provided one or more non-transitory machine-readable information storage mediums comprising one or more instructions which when executed by one or more hardware processors cause obtaining a first set of responses for a first set of questions from a user, wherein the first set of questions comprise one or more requirements specific to a design of an industrial entity; generating a second set of questions using one or more Large Language Models (LLMs) by refining the first set of questions based on the first set of responses; obtaining a second set of responses for the second set of questions from the user; generating, using one or more autonomous programs, one or more queries specific to a problem formulation comprising one or more sub problem formulations based on the second set of responses, wherein the one or more autonomous programs refer to one or more entities that perform at least one of one or more specific tasks or one or more operations; retrieving a first set of data corresponding to the one or more queries specific to the problem formulation from a knowledge base, by interacting with the knowledge base using the one or more autonomous programs; identifying missing data from the first set of data corresponding to the one or more queries specific to the problem formulation as one or more gaps; retrieving a second set of data from one or more accessible resources based on the identified one or more gaps; updating the knowledge base with the retrieved second set of data; and iteratively performing the following steps until the one or more requirements specific to the design of the industrial entity from the user is satisfied: retrieving at least one of one or more process models and corresponding one or more optimization models based on the second set of data updated in the knowledge base; selecting at least one relevant process model amongst the retrieved one or more process models based on the one or more queries specific to the problem formulation; evaluating at least one of the retrieved one or more optimization models corresponding to the selected relevant process model; selecting at least one relevant optimization model amongst the evaluated one or more optimization models; and obtaining feedback from the user based on the selection.

It is to be understood that both the foregoing general description and the following detailed description are exemplary and explanatory only and are not restrictive of the invention, as claimed.

### BRIEF DESCRIPTION OF THE DRAWINGS

The accompanying drawings, which are incorporated in and constitute a part of this disclosure, illustrate exemplary embodiments and, together with the description, serve to explain the disclosed principles:
FIG. 1 illustrates an exemplary system for design and optimization of industrial entity, according to some embodiments of the present disclosure.
FIG. 2 is a functional block diagram of the system for design and optimization of industrial entity, according to some embodiments of the present disclosure.
FIGS. 3A and 3B are flow diagrams illustrating the steps involved in the method for design and optimization of industrial entity, according to some embodiments of the present disclosure.
FIG. 4 is a block diagram illustrating a requirement gathering module, in conjunction with the method for design and optimization of industrial entity, according to some embodiments of the present disclosure.
FIG. 5 is a block diagram illustrating a requirement processing module, in conjunction with the method for design and optimization of industrial entity, according to some embodiments of the present disclosure.
FIG. 6 is a block diagram illustrating a design formulation module, in conjunction with the method for design and optimization of industrial entity, according to some embodiments of the present disclosure.
FIG. 7 is a block diagram illustrating a validator module, in conjunction with the method for design and optimization of industrial entity, according to some embodiments of the present disclosure.
FIGS. 8A and 8B are block diagrams illustrating the process of the system for design and optimization of industrial entity, according to some embodiments of the present disclosure.

### DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

Industrial equipment such as centrifugal pumps, turbines, and heat exchangers play a vital role in various industries.

Example of existing systems of heat exchanger designing and procedure:

Heat exchanger design and optimization covers a wide array of methods aimed at enhancing performance, efficiency, and cost-effectiveness. Typically, design approaches rely on both analytical and numerical methods. Analytical methods, such as the effectiveness-NTU (Number of Transfer Units) method (known in the art) and the log mean temperature difference (LMTD) approach (known in the art), are commonly used for basic calculations and preliminary design. More advanced techniques incorporate computational fluid dynamics (CFD) simulations (known in the art) to model complex flow and thermal behavior, while heuristic search techniques like genetic algorithms (known in the art), particle swarm optimization (PSO) (known in the art), and simulated annealing (known in the art) are frequently employed to fine-tune parameters like heat transfer surface area, fluid flow arrangement, and operating conditions. Additionally, design guidelines often utilize multi-objective optimization to balance competing goals, such as heat transfer efficiency, pressure drop, and material cost. The integration of machine learning models and surrogate-based optimization methods is becoming more prevalent, enabling faster and more accurate design solutions by predicting performance under varying conditions.

The literature on heat exchanger design and optimization encompassed various methods aimed at improving performance, cost-effectiveness, and energy efficiency. This study categorized the approaches into six main groups:
Group - 1: Minimization of Cost Based on Geometrical Parameters using a Mathematical Model and Optimization of Heat Exchanger Design Using Nature-Inspired Techniques
Group - 2: Thermal Design and Simulation
Group - 3: Exergy Analysis and Life Cycle Assessment
Group - 4: Optimization of Heat Exchanger Networks
Group - 5: Hybrid Mathematical Models
Group - 6: Minimization of Life Cycle Irreversibility and Maximization of Heat Transfer

Among these, the group 1, which is the most common method for design and optimization of heat exchangers, involved minimizing costs based on geometrical parameters using a mathematical model and optimizing heat exchanger design with nature-inspired techniques.

The mathematical model for heat exchanger design (known in the art) begins with the calculation of the tube-side heat transfer coefficient (*hₜ*) in a shell and tube heat exchanger. This coefficient is computed using correlations based on the Reynolds number (Re*ₜ*) and Prandtl number (Pr*ₜ*), with different formulas for laminar, turbulent, and very turbulent flow regimes. The flow velocity (*vₜ*) is derived from the fluid properties and tube dimensions, while the number of tubes (*Nₜ*) is calculated using an empirical relation based on the tube pitch and number of passes. For the shell side, the heat transfer coefficient (*hₛ*) is calculated using Kern's formulation (known in the art), considering fluid properties and the hydraulic diameter. The overall heat transfer coefficient (*U*) is derived by combining both the shell and tube-side heat transfer coefficients, fouling resistances, and the tube diameter ratio.

The Logarithmic Mean Temperature Difference (LMTD) (known in the art) is used to evaluate temperature variation across the heat exchanger, with a correction factor (*F*) applied based on the flow configuration. The heat exchanger surface area (*A*) is determined from the heat transfer rate and the overall heat transfer coefficient (*U*), while pressure drop calculations for both the tube and shell sides are performed to ensure an efficient system design. The optimization process focuses on minimizing the total cost, which includes capital investment, energy costs, and annual operating costs. Capital investment is directly related to the heat exchanger surface area, and the total discounted operating cost accounts for pumping power to overcome friction losses.

In addition to the basic model, various heat transfer models and pressure drop correlations are considered, including Nusselt number-based (known in the art) and flow regime-based approaches (known in the art) for the tube side, as well as Kern's method (known in the art) and Bell-Delaware method (known in the art) for the shell side.

In addition to the basic model, the optimization process involves different algorithms such as PSO, Genetic Algorithms (GA), and other techniques to further enhance the cost function optimization. The list of commonly used algorithms (known in the art) is given in the Table. 1 below.

**Table 1: List of commonly used algorithms**

| **Numbers** | **Optimization Algorithm** |
|---|---|
| 1 | Particle swarm optimization technique |
| 2 | Water cycle algorithm technique |
| 3 | Artificial Bee Colony (ABC) algorithm |
| 4 | Biogeography-based (BBO) algorithm |
| 5 | Cuckoo-search-algorithm |
| 6 | Ant Colony Optimization Technique |
| 7 | Jaya algorithm |
| 8 | Electromagnetism-like algorithm (EM) |
| 9 | Elitist-Jaya algorithm |
| 10 | Gravitational search algorithm |
| 11 | NSGA-II |
| 12 | Mixed-Integer Linear Programming |
| 13 | Teaching-learning-based optimization |
| 14 | Improved Intelligent Tuned Harmony Search algorithm |
| 15 | Elitist-Jaya algorithm |
| 16 | Tsallis differential evolution |
| 17 | Bacteria foraging algorithm |
| 18 | Rao Algorithm |
| 19 | Grey wolf optimization technique |
| 20 | Genetic algorithm |
| 21 | Harmony search algorithm |
| 22 | Firefly algorithm |
| 23 | Cohort intelligence algorithm |
| 24 | Heat transfer search algorithm |
| 25 | Sine Cosine Algorithm |
| 26 | Symbiotic organisms search technique |
| 27 | Bio-Inspired Artificial Intelligence Methods |

Despite the progress made in heat exchanger design and optimization, existing works have limitations. For instance, traditional design methods often rely on manual effort, trial-and-error approaches, and simplified models, which can lead to suboptimal designs and reduced efficiency.

The present disclosure addresses the above-mentioned issues by providing a system and method for design and optimization of industrial entity. The present disclosure obtains a first set of responses for a first set of questions from a user and generates a second set of questions using one or more Large Language Models (LLMs) by refining the first set of questions based on the first set of responses. The present disclosure further obtains a second set of responses from the user for the second set of questions. The present disclosure further generates one or more questions specific to a problem formulation comprising one or more subproblem formulations based on the second set of responses using one or more autonomous programs. The present disclosure further retrieves a first set of data corresponding to the one or more questions specific to the problem formulation from a knowledge base, by interacting with the knowledge base using the one or more autonomous programs. The present disclosure identifies missing data from the first set of data corresponding to the one or more questions specific to the problem formulation as one or more gaps. Further a second set of data is retrieved from at least one of one or more accessible resources based on the identified one or more gaps and the knowledge base is updated with the retrieved second set of data. The following steps are performed iteratively until the one or more requirements specific to the design of the industrial entity from the user are satisfied. At least one of one or more process models and corresponding one or more optimization models are retrieved based on the second set of data updated in the knowledge base. At least one relevant process model amongst the retrieved one or more process models is selected based on the one or more questions specific to the problem formulation. At least one of the retrieved one or more optimization models corresponding to the selected relevant process model are evaluated. Relevant one or more optimization models is selected based on the evaluation and feedback is obtained from the user based on the selection.

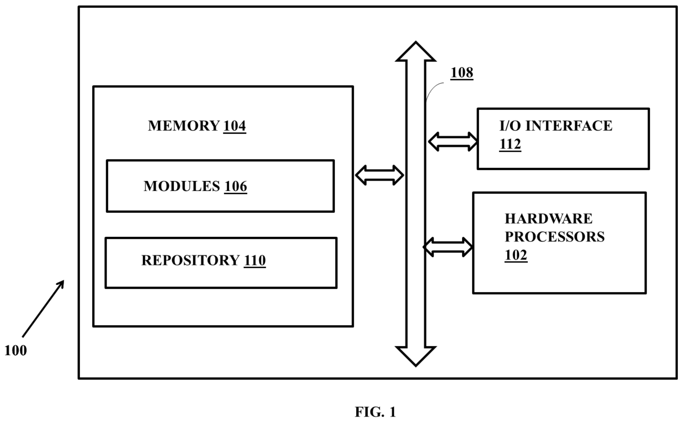

Referring now to the drawings, and more particularly to FIGS. 1 through FIG. 8B, where similar reference characters denote corresponding features consistently throughout the figures, there are shown preferred embodiments, and these embodiments are described in the context of the following exemplary system and/or method.

FIG. 1 illustrates an exemplary system for design and optimization of industrial entity, according to some embodiments of the present disclosure. In an embodiment, the system 100 includes or is otherwise in communication with hardware processors 102, at least one memory such as a memory 104, and an I/O interface 112. The hardware processors 102, memory 104, and the Input /Output (I/O) interface 112 may be coupled by a system bus such as a system bus 108 or a similar mechanism. In an embodiment, the hardware processors 102 can be one or more hardware processors.

The I/O interface 112 may include a variety of software and hardware interfaces, for example, a web interface, a graphical user interface, and the like. The I/O interface 112 may include a variety of software and hardware interfaces, for example, interfaces for peripheral device(s), such as a keyboard, a mouse, an external memory, a printer and the like. Further, the I/O interface 112 may enable the system 100 to communicate with other devices, such as web servers, and external databases.

The I/O interface 112 can facilitate multiple communications within a wide variety of networks and protocol types, including wired networks, for example, local area network (LAN), cable, etc., and wireless networks, such as Wireless LAN (WLAN), cellular, or satellite. For this purpose, the I/O interface 112 may include one or more ports for connecting several computing systems with one another or to another server computer. The I/O interface 112 may include one or more ports for connecting several devices to one another or to another server.

The one or more hardware processors 102 may be implemented as one or more microprocessors, microcomputers, microcontrollers, digital signal processors, central processing units, node machines, logic circuitries, and/or any devices that manipulate signals based on operational instructions. Among other capabilities, the one or more hardware processors 102 is configured to fetch and execute computer-readable instructions stored in memory 104.

The memory 104 may include any computer-readable medium known in the art including, for example, volatile memory, such as static random-access memory (SRAM) and dynamic random-access memory (DRAM), and/or non-volatile memory, such as read only memory (ROM), erasable programmable ROM, flash memories, hard disks, optical disks, and magnetic tapes. In an embodiment, the memory 104 includes a plurality of modules 106. The memory 104 also includes a data repository (or repository) 110 for storing data processed, received, and generated by the plurality of modules 106.

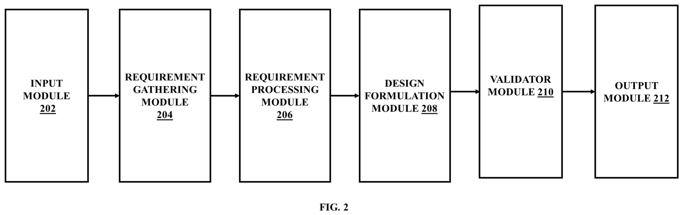

The plurality of modules 106 includes programs or coded instructions that supplement applications or functions performed by the system 100 for design and optimization of industrial entity. The plurality of modules 106, amongst other things, can include routines, programs, objects, components, and data structures, which perform particular tasks or implement particular abstract data types. The plurality of modules 106 may also be used as signal processor(s), node machine(s), logic circuitries, and/or any other device or component that manipulates signals based on operational instructions. Further, the plurality of modules 106 can be used by hardware, by computer-readable instructions executed by the one or more hardware processors 102, or by a combination thereof. The plurality of modules 106 can include various sub-modules (not shown). The plurality of modules 106 may include computer-readable instructions that supplement applications or functions performed by the system 100 for design and optimization of industrial entity. In an embodiment, the modules 106 include an input module 202, a requirement gathering module 204, a requirement processing module 206, a design formulation module 208, a validator module 210 and an output module 212. The modules are depicted in FIG. 2. These modules that are depicted in FIG. 2 are implemented as at least one of a logically self-contained part of a software program, a self-contained hardware component, and/or a self-contained hardware component with a logically self-contained part of a software program embedded into each of the hardware component that when executed perform the above method described herein, in one embodiment of the present disclosure.

The data repository (or repository) 110 may include a plurality of abstracted pieces of code for refinement and data that is processed, received, or generated as a result of the execution of the module(s) 106.

Although the data repository 110 is shown internal to the system 100, it will be noted that, in alternate embodiments, the data repository 110 can also be implemented external to the system 100. The data contained within such an external database may be periodically updated. For example, new data may be added into the database (not shown in FIG. 1) and/or existing data may be modified and/or non-useful data may be deleted from the database. In one example, the data may be stored in an external system, such as a Lightweight Directory Access Protocol (LDAP) directory and a Relational Database Management System (RDBMS).

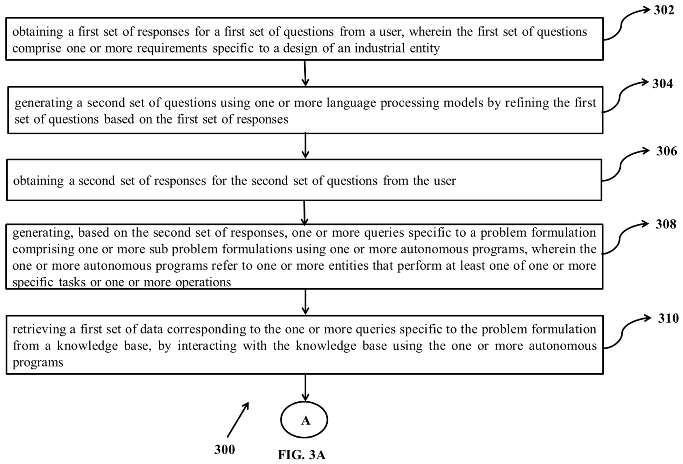

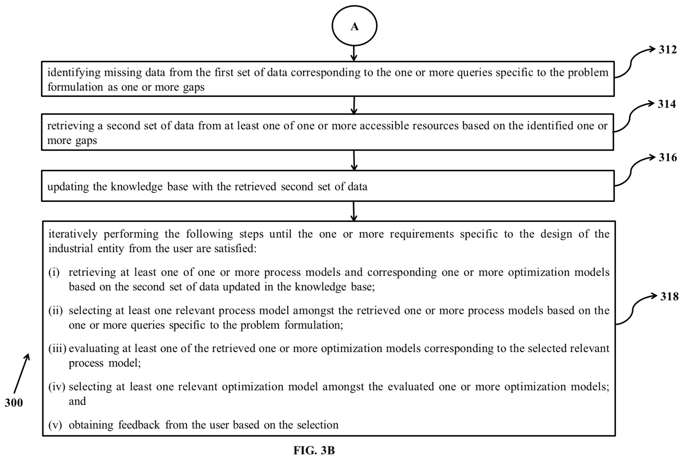

FIGS. 3A and 3B are flow diagrams illustrating a method for design and optimization of industrial entity using the systems 100 of FIGS. 1-2, according to some embodiments of the present disclosure. Steps of the method of FIGS. 3A and 3B shall be described in conjunction with the components of FIG. 2. At step 302 of the method 300, the input module 202 executed by the one or more hardware processors 102 obtains a first set of responses for a first set of questions from a user, wherein the first set of questions comprise one or more requirements specific to a design of an industrial entity. The design of the industrial entity comprises at least one of an engineering design or process design including at least one of a thermal design, a mechanical design, and a system design.

At step 304 of the method 300, the requirement gathering module 204 executed by the one or more hardware processors 102 generates a second set of questions using one or more Large Language Models (LLMs) by refining the first set of questions based on the first set of responses.

At step 306 of the method 300, the requirement gathering module 204 executed via the one or more hardware processors 102 obtains a second set of responses for the second set of questions from the user.

At step 308 of the method 300, the requirement gathering module 204 executed via the one or more hardware processors 102 generates, using one or more autonomous programs, one or more questions specific to a problem formulation comprising one or more subproblem formulations based on the second set of responses.

The one or more autonomous programs refer to entities that perform specific tasks or operation. The one or more autonomous programs can be viewed as computational or logical units that carry out predefined actions or decisions to achieve the overall goal, such as optimizing the design or analyzing system performance.

Example of an autonomous program is explained below:
Optimization Program (*A_{O}*): Independently generates the optimization model.

### 1. Inputs:

Processed finalized data from knowledge base: This input data provides the detailed description of the optimization algorithm, including the objective function, constraints, and other parameters. This input data contains the theoretical foundation and steps needed to construct the optimization algorithm based on user's requirement.

### 2. Process:

- The autonomous program reads and analyzes the provided input data to extract relevant information about the optimization algorithm, including the objective function, constraints, bounds on variables, and optimization parameters.
- **Define the Optimization Problem:** Based on the information, the program defines the optimization problem, including:
   The objective function (e.g., to minimize or maximize a particular value).
   The constraints (e.g., limitations on variables, bounds).
   The bounds are on variables (e.g., specific ranges for design variables, such as internal diameters, or spacing).
- **Construct the Optimization model:** The autonomous program then generates the model that constructs the optimization algorithm based on the user's description. This includes:
   Defining the optimization problem using the correct syntax and parameters.
   Specifying key optimization parameters, such as learning rate, population size, or number of iterations.
- **Verification:** The program cross-checks the generated model to ensure it matches the user's requirements.

### 3. Components:

- **Input Parsing Module:** This component handles the ingestion and parsing of the knowledge base data to extract the necessary information.
- **Algorithm Definition Engine:** This is where the optimization problem is defined, including the objective function, constraints, and variable bounds.
- **Model Generation Module:** This component generates the model for the optimization algorithm, ensuring it follows the user requirement's description and properly formats the parameters and constraints.
- **Verification Engine:** The system verifies that the generated optimization model matches the theoretical algorithm described in the input data.

### 4. Outputs:

- **Generated Optimization model:** The primary output is a model that constructs the optimization algorithm. This includes the objective function, constraints, and other parameters.
- **Verification Report:** An optional output that confirms that the generated model aligns with the optimization algorithm as per user's requirement.
- **Actionable Feedback (if needed):** If any discrepancies or issues are found in the input data or in the generation process (e.g., missing or unclear details), the program may provide suggestions or request clarification before generating the final model.

Each of the one or more autonomous programs in the present disclosure typically serves a specific function, such as gathering user requirements, processing design information, searching for one or more optimization models, generating one or more mathematical models, performing code validation, and more. The one or more autonomous programs can either work independently or collaborate with other autonomous programs in a coordinated manner to progress through the different stages of the design and optimization process. Each of the one or more autonomous program's role is typically well-defined to ensure that tasks are carried out efficiently and in accordance with the overall system objectives.
For example: **Requirement Gathering program** (***A_{RG}***): This autonomous program is responsible for gathering information by asking the first set of questions and the second set of questions to the user and collecting the first set of responses and the second set of responses to the user. Initially, the first set of questions are posed to the user to collect basic requirements (the one or more requirements specific to the design of the industrial entity).
**Design Formulation program (*A_{DF}*):** This autonomous program is responsible for searching for top one or more process models and top one or more optimization models based on the formulated requirements '*Dᵣ*' (the one or more requirements specific to the design of the industrial entity). The search retrieves the top one or more process models and the one or more optimization models that are used for generating one or more mathematical models and optimizing the design.

At step 310 of the method 300, the requirement processing module 206 executed by the one or more hardware processors 102 retrieves a first set of data corresponding to the one or more questions specific to the problem formulation from a knowledge base, by interacting with the knowledge base using the one or more autonomous programs. The one or more subproblem formulations comprise at least one of a design of an industrial entity and one or more operational constraints specific to the industrial entity.

The knowledge base (KB) is structured into three main sections. The first section stores various types of existing optimization algorithms (optimization models), which can be updated over time to incorporate new state-of-the-art (SOTA) optimization techniques. The second section contains the one or more mathematical models relevant to different industrial entities, such as heat exchangers, each accompanied by one or more predefined variables and values specific to the one or more mathematical models. The third section focuses on process analysis, including the names of key variables and their associated values that are used in conjunction with the one or more mathematical models. This structure of the knowledge base allows for easy expansion and adaptability as new models, algorithms, and process variables are developed. There is another section in the knowledge base containing potential errors that may arise while executing the final code, along with possible solutions to those errors.

### Example for one of the one or more mathematical models is explained below: (Based on flow regime calculation on Kern's method (known in the art))

### Equations:

### Calculate the heat transfer co-efficient.

For *Re* ≤ 2300: ${h}_{t} = \frac{{k}_{t}}{{d}_{i}} \left(3.657+\frac{0.0677 {\left({Re}_{t}⋅{Pr}_{t}⋅{\left(\frac{{d}_{i}}{L}\right)}^{1.33}\right)}^{0.33}}{1 + 0.1 ⋅ {Pr}_{t} ⋅ {\left({Re}_{t}⋅\frac{{d}_{i}}{L}\right)}^{0.3}}\right)$

For 2300 < *Re* ≤ 10000 ${h}_{t} = \frac{{k}_{t}}{{d}_{i}} ⋅ \frac{\frac{{f}_{t}}{8} ⋅ \left({Re}_{t}-1000\right) ⋅ {Pr}_{t} \left(1+{\left(\frac{{d}_{i}}{L}\right)}^{0.67}\right)}{1 + 12.7 ⋅ {\left(\frac{{f}_{t}}{8}\right)}^{0.5} ⋅ \left({{Pr}_{t}}^{0.667}-1\right)}$

For *Re* > 10000: ${h}_{t} = 0.027 ⋅ \frac{{k}_{t}}{{d}_{o}} ⋅ {{Re}_{t}}^{0.8} ⋅ {{Pr}_{t}}^{0.33} ⋅ {\left(\frac{{μ}_{t}}{{μ}_{wt}}\right)}^{0.14}$

**Example set of real-world values for the one or more predefined variables.**
# Input parameters
*mₛ* = 5.52 kg/s
*ρₛ* = 850 kg/m³
*Cₚₛ* = 2.47 kJ/kgK
*kₛ* = 0.13 W/mK
µ*ₛ* = 0.0004 Pa.s
µ*_{w}* = 0.0004 Pa.s
*Tᵢₛ* = 199 K
*Tₒₛ* = 93.3 K
*mₜ* = 18.80 kg/s
ρ*ₜ* = 995 kg/m³
*Cₚₜ* = 2.05 kJ/kgK
*kₜ* = 0.13 W/mK
µ*ₜ* = 0.00358 Pa.s
*Tᵢₜ* = 37.8 K
*Tₒₜ* = 76.7 K
*Pₜ* = 0.0254 m
*dₒ* = 0.0254 m
*dᵢ* = 0.0194 m
*L* = 4.88 m
*nₜ* = 4 (number of tube passes)
*Nₜ* = 2625 (number of tubes)
*b* = 0.127 m
*Dₛ* = 0.54 m
*Rₗₛ* = 0.00061 m²*K*/*W*
*Rₗₜ* = 0.00061 m²*K*/*W*
*fₛ* = 0.33 (friction factor for shell side)
*fₜ* = 0.028 (friction factor for tube side)
*p* = 4 (number of tube passes)
*C_{E}* = *Cₑ* (cost of electricity)
*A* = 7000 (annual operating hours)
*I* = 0.1 (interest rate)
*v_{y}* = 10 (number of years)
η = 0.8 (efficiency of pump)

At step 312 of the method 300, the requirement processing module 206 executed via the one or more hardware processors 102 identifies missing data from the first set of data corresponding to the one or more questions specific to the problem formulation as one or more gaps.

At step 314 of the method 300, the requirement processing module 206 executed via the one or more hardware processors 102 retrieves a second set of data from at least one of one or more accessible resources based on the identified one or more gaps. The one or more accessible resources comprise at least one of one or more articles, one or more web articles, one or more design manuals and a digital book. The digital book (e.g., refer "https://ahtt.mit.edu/wp-content/uploads/2020/08/AHTTv510.pdf") includes various components such as process models, mathematical equations related to the industrial entity, optimization algorithms (which may or may not be applied to the same entity), background information, process analysis, and any other materials needed by the user to develop the design and optimization of the industrial entity, such as a heat exchanger.

At step 316 of the method 300, the requirement processing module 206 executed via the one or more hardware processors 102 updates the knowledge base with the retrieved second set of data.

At step 318 of the method 300, the design formulation module 208, the validator module 210 and the output module 212 executed via the one or more hardware processors iteratively perform the following steps until the one or more requirements specific to the design of the industrial entity from the user are satisfied. At least one of the one or more process models and the corresponding one or more optimization models are retrieved based on the second set of data updated in the knowledge base. At least one relevant process model amongst the retrieved one or more process models are selected based on the one or more questions specific to the problem formulation. At least one of the retrieved one or more optimization models corresponding to the selected relevant process model are evaluated. The relevant one or more optimization models are selected based on the evaluation. Feedback from the user is obtained based on the selection.

The one or more requirements refer to the complete design and optimization code for the industrial entity. The user reviews the generated code for the entire system, including the process analysis. If the user feels that the delivered solution (i.e., the design and optimization model) does not meet their original requirements, the user might be dissatisfied. The user is satisfied only when the correct/required design and optimization model is generated. At that point, the user can decide whether they want to continue with further adjustments or stop the process (design and optimization model generation process) altogether.

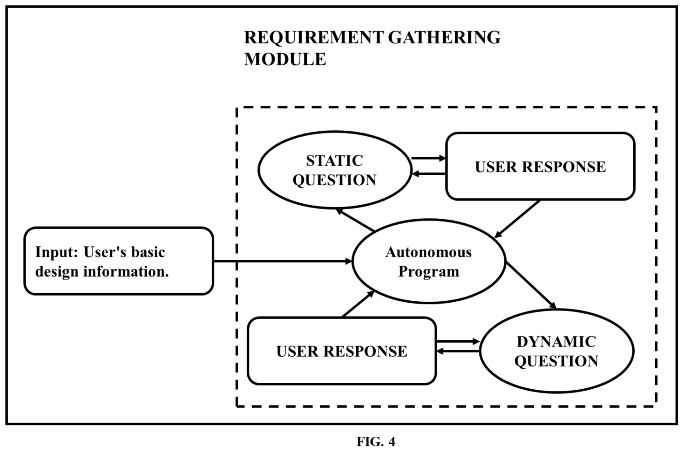

FIG. 4 is a block diagram illustrating the requirement gathering module 204 of FIG. 2, in conjunction with the method for design and optimization of industrial entity, according to some embodiments of the present disclosure. The user is presented with a set of static questions (i.e., the first set of questions) to gather basic design information. If a specific option is selected, additional relevant questions are asked to refine the design. For custom or new methods, dynamic questions (i.e., the second set of questions) are generated based on the user's input (i.e., the first set of responses). An interactive discussion confirms the gathered requirements before moving to the requirement processing module 206.

Initially, a set of static questions (i.e., the first set of questions) (SQ^{x}1, SQ^{x}2, ..., SQ^{x}n) is presented to the user. For example, the heat exchanger design and optimization process, the static questions might include:
- **SQ¹1**: What type of heat exchanger design would you like? (e.g., shell and tube, plate, or fin)
- **SQ¹2**: What material should the heat exchanger be made of?
- **SQ¹3**: If the user chooses a shell and tube heat exchanger, should the heat transfer coefficient design be based on Kern's method or the Bell-Delaware method?
If the user chooses Kern's method for the design, a new set of static questions will be presented:
- **SQ²1**: What is the number of tubes?
- **SQ²2**: What is the tube side fluid velocity?
- **SQ²3**: What is the tube side fluid dynamic viscosity?

And so on.

However, if the user selects the shell and tube heat exchanger design, but the chosen design and optimization method is not listed in the set of static questions (i.e., the first set of questions), the dynamic set of questions (i.e., the second set of questions) will be generated. This is done with the help of the one or more Large Language Models (LLMs). For example, the optimization process may include 27 predefined techniques (as represented in Table 1), but if a new technique is suggested, the dynamic questions (i.e., the second set of questions) could be:
- **DQ^{x}1**: What new optimization technique would you like to select?
- **DQ^{x}2**: What are the design variables?
- **DQ^{x}3**: What are the boundary conditions?
Here, 'x' represents the current iteration of the process.
Response to DQ^{x}1: A new optimization technique, such as PSO, based on the user's preferences or requirements.
Response to DQx2: Shell inside diameter (Ds), tubes outer diameter (do), baffle spacing (B)
Response to DQx3: shell inside diameter (Ds) ranging between 0.1 m and 1.5 m; tubes outer diameter (do) ranging between 0.015 m and 0.051 m; baffle spacing (B) ranging from 0.05 m to 0.5 m.
It is to be noted by a person having ordinary skill in the art of person skilled in the art that the example of 27 predefined techniques shall not be construed as limiting the scope of the present disclosure.
Following this, an interactive discussion occurs between the automated program and the user. Both static and dynamic questions are addressed, and the requirement gathering module explains the requirements and their impact on the final solution. The user confirms these before the process moves forward to the requirement processing module 206.

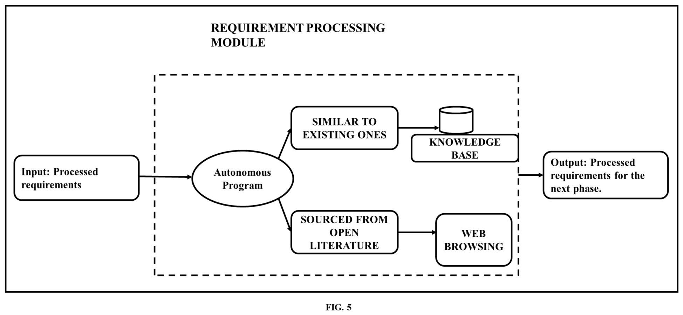

FIG. 5 is a block diagram illustrating a requirement processing module 206 of FIG. 2, in conjunction with the method for design and optimization of industrial entity, according to some embodiments of the present disclosure. The one or more autonomous programs interacts with the knowledge base to compare the collected one or more requirements with the existing design methods or identify the one or more gaps.

After collecting one or more requirements from the user, the one or more autonomous programs generate multiple queries based on the input (i.e., the first set of responses and the second set of responses) from the user. The answers (i.e., the first set of data) to these multiple queries are then compared with the knowledge base to check if a design method corresponding to the multiple questions exists. For example, if the user requests a newly launched state-of-the-art optimization algorithm, and this algorithm is not found in the knowledge base, then it is treated as a gap. In such cases, the one or more autonomous programs search for the algorithm in the one or more accessible resources like open literature or web browsing capabilities.

If the design method is already available in the knowledge base, it is considered as a match, and the information will be stored for use in the design formulation module 208. For example, based on the collected one or more requirements, the one or more autonomous programs might ask, 'What is the tube-side heat transfer coefficient based on flow regime method?" The answer to this question is then compared with the knowledge base, if the method is found, then the system 100 confirms the process models for tube-side heat transfer coefficient based on flow regime method is present, else the method is treated as a gap. Missing details (one or more gaps) are sourced from open literature using web browsing capabilities and one or more inputs (i.e., the first set of responses and the second set of responses) obtained from the user. Once all the one or more requirements are finalized, the one or more autonomous programs proceed with the design formulation module 208.

After collecting the necessary information from the user, the one or more autonomous programs interact with the knowledge base to determine if the one or more requirements are similar to existing ones or if these need to be sourced from open literature.
- The one or more autonomous programs then either retrieves design methods from the knowledge base or plan to utilize open-source design information.
- Another autonomous program assesses whether the available information is complete or if further requirement analysis is needed for missing details.
For example, if the knowledge base contains three design methods (which includes process models (mathematical model) and optimization techniques). for shell and tube heat exchangers-based on Kern's method, Bell-Delaware method, or flow stream analysis (known in the art) and the gathered requirements are most similar to Kern's method, the program stores this information for the design formulation module 208. If any necessary information is still missing (such as the dynamic viscosity of the tube-side fluid, which the user did not provide), the one or more autonomous programs fetches the required data from open literature using web browsing capabilities. For example, with the help of the one or more autonomous programs, it will generate a question asking for the value of the dynamic viscosity of the tube-side fluid, then search for it through web browsing. (For e.g., refer "https://www.sciencedirect.com/science/article/abs/pii/S1359431110001080 (Open-access resource titled 'Design Optimization of Shell-and-Tube Heat Exchanger Using Particle Swarm Optimization Technique")). Once the missing details are retrieved, the autonomous program discusses them with the user to finalize the requirements. Once the requirement processing is complete, the program proceeds to the design formulation module 208.

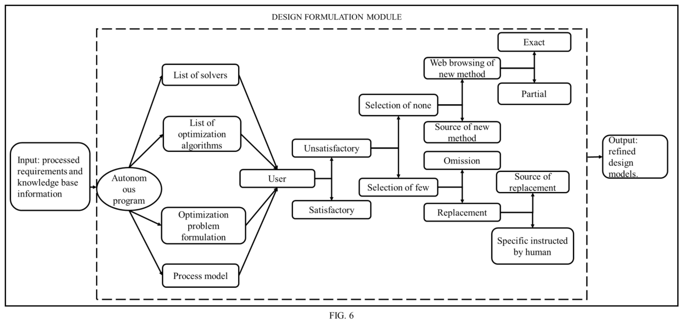

FIG. 6 is a block diagram illustrating the design formulation module 208 of FIG. 2, in conjunction with the method for design and optimization of industrial entity, according to some embodiments of the present disclosure. The system 100 searches for the top one or more process models and the top one or more optimization models based on available and missing information. The knowledge base is used to identify suitable optimization models. The user is presented with the results (i.e., the top one or more process models and the top one or more optimization models ) and asked if the response is satisfactory. If not, the system 100 evaluates inaccuracies and either adjusts the top one or more process models and the top one or more optimization models or searches for alternative solutions. The iterative process ensures continuous refinement of the design based on user feedback and available data. The one or more optimization models include Particle Swarm Optimization (PSO) or Genetic Algorithm (GA). The one or more process models can include a total cost calculation model for the heat exchanger, in case of a shell and tube heat exchanger design and optimization. In this case, the heat transfer coefficient or pressure drop calculations for both the tube side and shell side can be determined based on methods such as Kern's method, Bell-Delaware method, or flow stream analysis etc.

After the requirement processing module 206, the system transitions to the design formulation module 208. In this phase (design formulation module 208), the system 100, assisted by the one or more autonomous programs and the one or more Large Language Models (LLMs), begins a search based on the available or missing information. The one or more autonomous programs retrieve the top one or more process models, for example, which may include heat transfer equations for heat exchangers, and the top one or more optimization problem formulation models ( i.e., optimization models) focusing on objectives such as cost and efficiency. For example, if the user's requirement matches the design and optimization of a single shell and tube heat exchanger aiming to minimize total cost, the process models could include Kern's mathematical model for heat exchanger design, followed by the Bell-Delaware method, and finally, the flow stream analysis method as the top one or more process models. In this case, the top one or more optimization models might include total cost optimization or maximization of heat transfer. Next, the system 100 interacts with the knowledge base to generate a list of suitable optimization models.

The next step is selecting the relevant one or more optimization models. For instance, based on the user's requirement and the optimization problem formulation, the one or more autonomous programs might select Particle Swarm Optimization and Genetic Algorithm as the most appropriate algorithms, forming a top list of the one or more optimization models. Once the search process is completed, the user is presented with two options: either the response is satisfactory, or it is not. If the response is unsatisfactory, the system 100 evaluates whether the issue (i.e., the identified one or more gaps) is partially or entirely incorrect. In cases of partial inaccuracies, the system 100 uses the one or more autonomous programs and the one or more Large Language Models (LLMs) to decide whether to replace certain elements/components comprised in the one or more optimization models, based on the source (i.e., one or more accessible resources or the web browsing capabilities) and content of the replacement (modify based on the response from the user), or whether to exclude certain elements/components altogether. If the user deems the response entirely incorrect, the system will either prompt the user for new methods or autonomously search the internet (i.e., web browsing capabilities) for alternative approaches. This iterative approach ensures a dynamic and flexible process that refines and improves the design formulation through intelligent interaction and evaluation, constantly adapting to user feedback and available information. Examples of the one or more Large Language Models (LLMs) can be Generative Pre-training Transformer (GPT) series, Claude series ^{®}, open source LLMs like LLama series ^{®}, or it can be Bidirectional Encoder Representations from Transformers (BERT) ^{®} and gemini flash ^{®}.

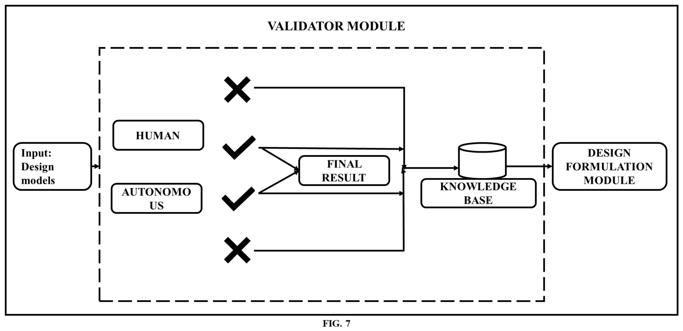

FIG. 7 is a block diagram illustrating the validator module 210 of FIG. 2, in conjunction with the method for design and optimization of industrial entity, according to some embodiments of the present disclosure.

The validator module 210 validates the outcomes generated by the design formulation module 208. Two types of validators are employed for this process. The first is an autonomous program that tests the final model against various edge cases, while the second is a human validator. The output validation yields four possible combinations, but the process is only considered successful if both the autonomous program and the human validator approve the results. Examples for the possible combinations include:
- Approved by both human and autonomous program validator.
- Approved by human but not by the program validator.
- Approved by the program validator but not by human.
- Not approved by either the program validator or human.

In cases where the validation fails, the system 100 interacts with the knowledge base (KB) to identify potential errors and solutions. For example, If the system encounters an error while executing the final optimized model code, such as a "ValueError: math domain error," the system 100 will first check the knowledge base (KB) for potential solutions. The KB may contain relevant troubleshooting information or predefined solutions for this specific error.
For instance, the KB might suggest solutions as provided below:
The error message "ValueError: math domain error" occurs when a math function is used with an argument that is outside of its domain. In this case, the issue likely arises from the calculation of the denominator in the Correction_factor function. The logarithm function cannot accept negative arguments or arguments that result in a negative value inside the logarithm.
To resolve this issue, the Correction_factor function was modified to handle these cases by checking if the denominator is zero or negative before calculating the logarithm.
Here's an updated version of the Correction_factor function: python code def Correction_factor(Th_i, Th_o, Tc_i, Tc_o): $R = \left(Th_i-Th_o\right) / \left(Tc_o-Tc_i\right)$ $P = \left(Tc_o-Tc_i\right) / \left(Th_i-Tc_i\right)$ if R <= 1 or P <= 0 or P >= 1: return 1 # Return a default value of 1 if the arguments are invalid numerator = math.sqrt(R**2 + 1) / (R - 1)) # Handle the case when the denominator is zero or negative if (2 - P * R + 1 - math.sqrt(R**2 + 1)) <= 0 or (2 - P * R + 1 + math.sqrt(R**2 + 1)) <= 0: return 1 # Return a default value of 1 if the denominator is zero or negative denominator = math.log (2 - P * R + 1 - math.sqrt(R**2 + 1)) / (2 - P * R + 1 + math.sqrt(R**2 + 1))) F = numerator * denominator return F
With this modification, the function will return 1 when the denominator is zero or negative, avoiding the math domain error. ‴.
metadata= {"Error":"ValueError: math domain error"},
If no solution is found in the KB, the system, using the one or more autonomous programs and the one or more Large Language Models (LLMs), attempts to diagnose and fix the issue on its own. Additionally, the system may search open-source resources, forums, or documentation for a possible solution.

If the required information is not found in the knowledge base (KB), the system 100 searches open-source resources and obtains input/feedback from users/humans in the form of any relevant knowledge or suggestions. The issue (i.e., the identified one or more gaps) is then analyzed, and the system 100 generates the correct/appropriate results.

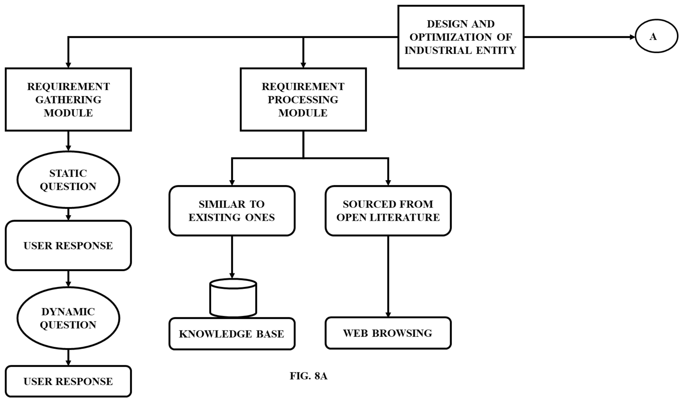

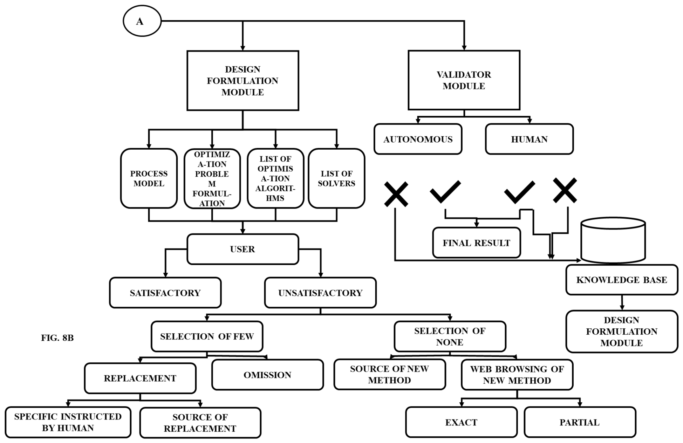

FIGS. 8A and 8B are block diagrams illustrating the process of the system for design and optimization of industrial entity, according to some embodiments of the present disclosure. Pseudo-code for the entire process of the system for design and optimization of industrial entity is explained below:

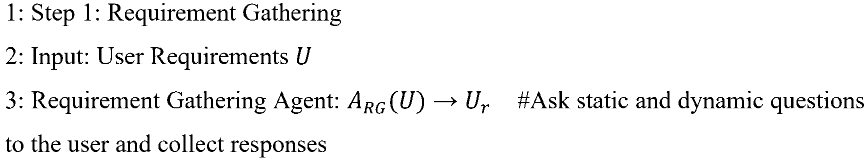

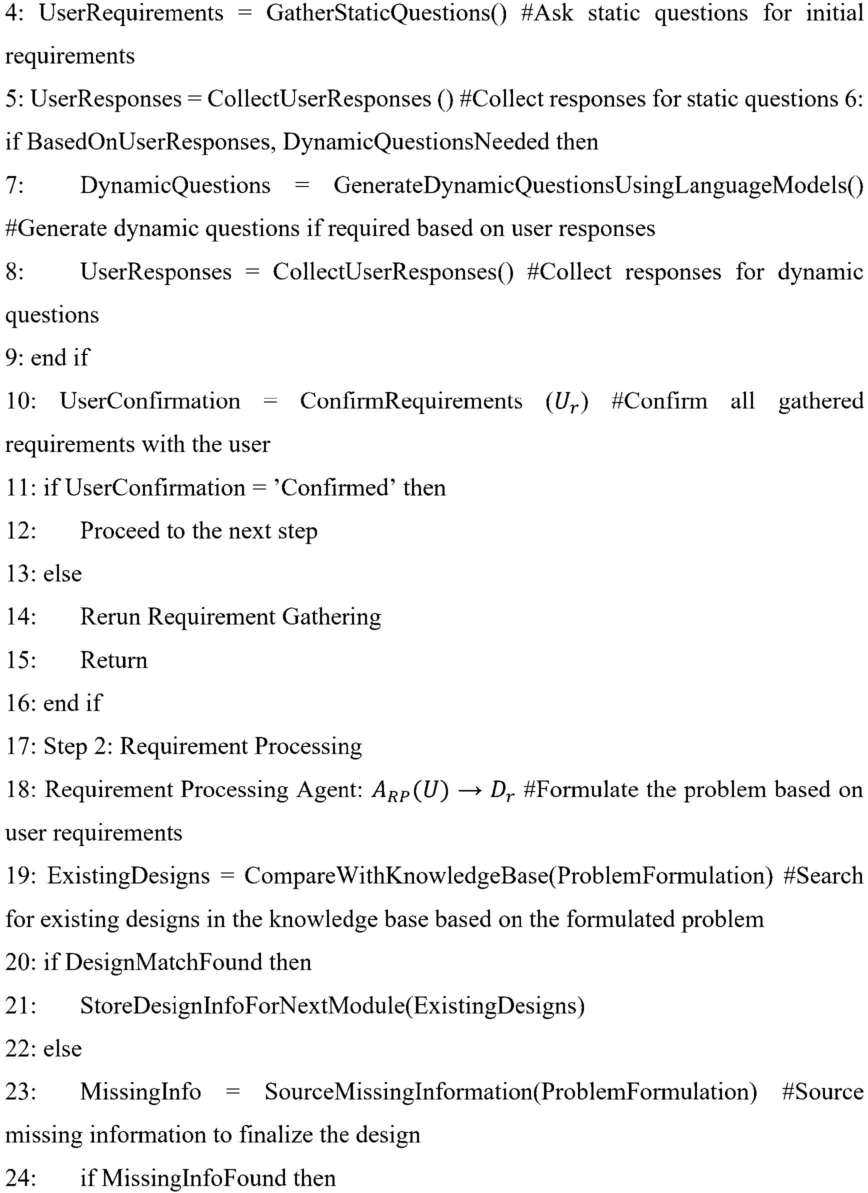

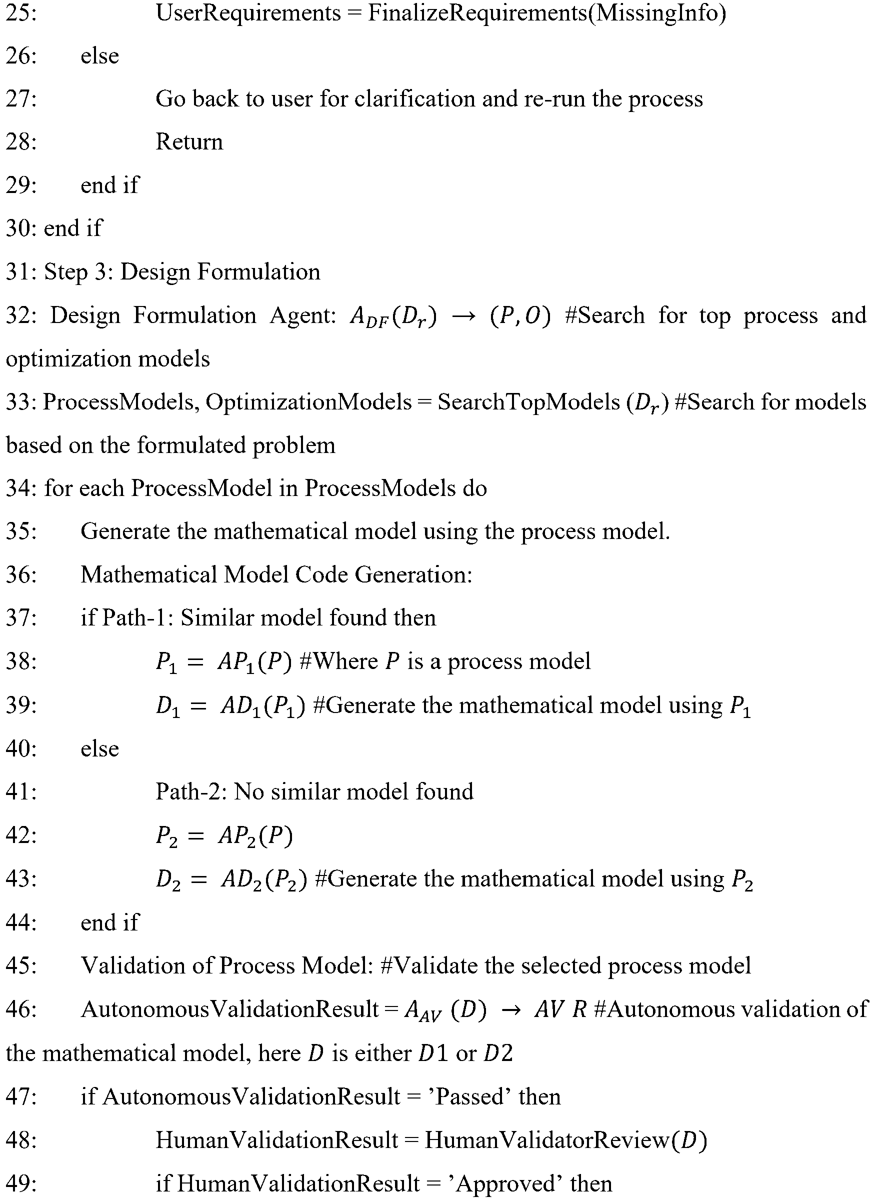

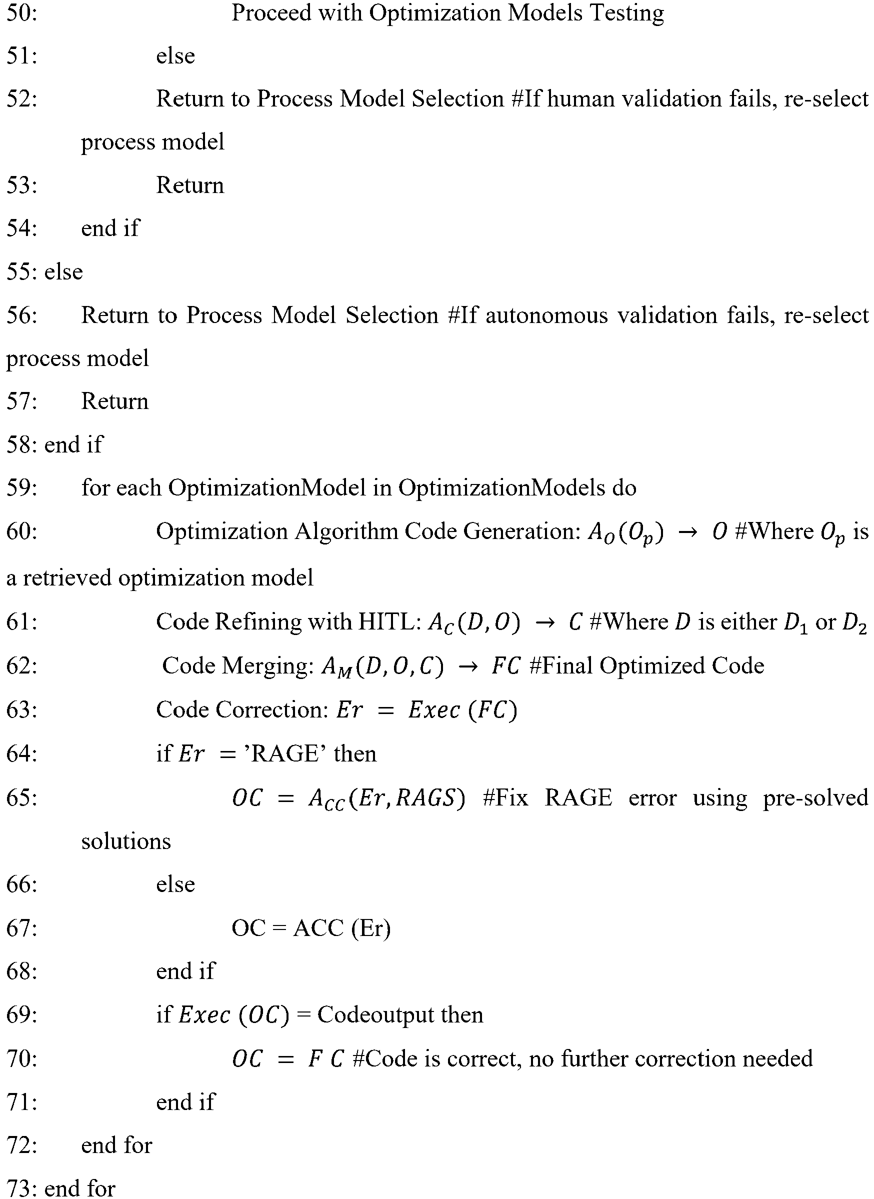

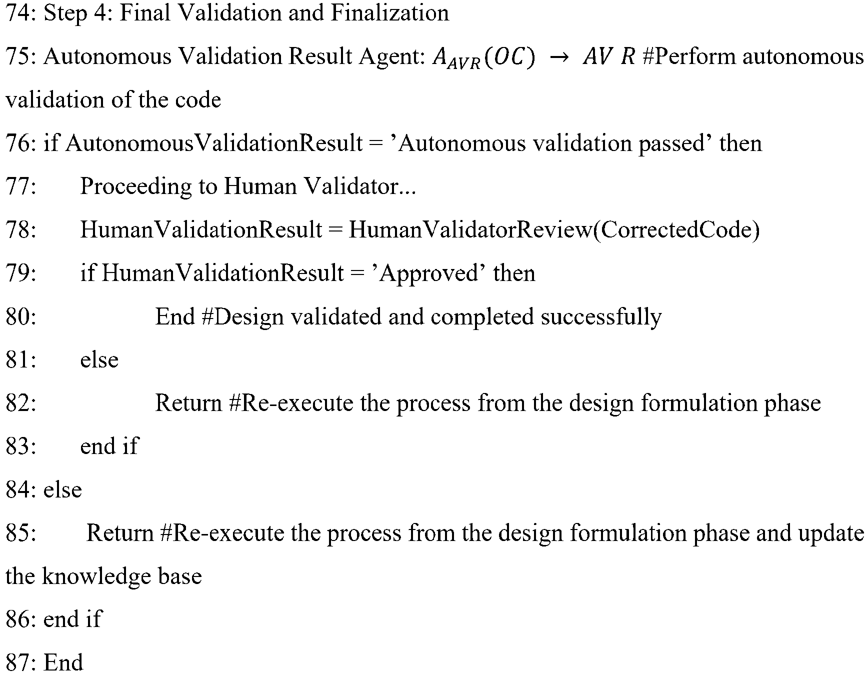

The system 100 offers numerous benefits, including:
1. **Reduced Dependence on Human Experts:** By leveraging the one or more autonomous programs and a comprehensive knowledge base, the need for human experts or teams of experts is significantly minimized.
2. **Enhanced Interaction:** While users can interact with commercial tools, they are not solely reliant on them, providing greater flexibility and autonomy in the design and optimization process. In the existing systems, the users could only interact with the tool in a limited, predefined manner. However, the proposed system offers significantly enhanced interaction capabilities. The users now have the flexibility to engage with the entire model-building process. The users can view and modify each stage of the code, allowing them to customize specific modules according to their needs. For example, in the optimization algorithm, users are no longer confined to a fixed structure. The users can now adjust parameters, modify constraints, or even change the optimization logic itself to better suit their unique requirements. This provides the users with greater autonomy and control, facilitating a more dynamic and tailored approach to design and optimization.
3. **Incorporating SOTA Methods:** The system 100 makes it easy and less time-consuming to incorporate state-of-the-art methods, ensuring that the design and optimization process is always up-to-date and effective. The proposed system simplifies the process of incorporating state-of-the-art (SOTA) methods, making it significantly easier and less time-consuming. In the existing systems, users had to manually build models and refer to detailed manuals to integrate new SOTA techniques. This process was often complex and time intensive. However, with the proposed system, users can now seamlessly integrate these advanced methods through an interactive, chat-based interface. The proposed system guides users step-by-step, helping them define their requirements and automatically suggesting or implementing the appropriate SOTA techniques until the requirements are fully satisfied. This eliminates the need for manual model-building and reduces the time spent learning complex methods, making the entire process faster and more efficient.
4. **Empowered User Experience:** The proposed system's interactive nature enables users to engage in more experimentation, exercise greater control over the design process, and ultimately, discover new optimal designs that never existed before.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

Existing design methods often rely on manual effort, trial-and-error approaches, and simplified models, which can lead to suboptimal designs and reduced efficiency. The present disclosure provides a system and method for design and optimization of industrial entity. The present disclosure provides a repository of design and optimization knowledge base derived from advanced/ cutting-edge models and methodologies. The present disclosure proposes the implementation of one or more autonomous program suites, which are interconnected systems that collaborate with the knowledge base to enhance the development of new solutions and improvements in design and optimization processes. Further, the present disclosure utilizes the one or more Large Language Models (LLMs) to facilitate seamless interaction between programs and the knowledge base for continuous improvement.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

## Claims

1. A processor implemented method (300), comprising:
obtaining (302), via one or more hardware processors, a first set of responses for a first set of questions from a user, wherein the first set of questions comprise one or more requirements specific to a design of an industrial entity;
generating (304), via the one or more hardware processors, a second set of questions using one or more Large Language Models (LLMs) by refining the first set of questions based on the first set of responses;
obtaining (306), via the one or more hardware processors, a second set of responses for the second set of questions from the user;
generating (308), via the one or more hardware processors, using one or more autonomous programs, one or more queries specific to a problem formulation comprising one or more sub problem formulations based on the second set of responses, wherein the one or more autonomous programs refer to one or more entities that perform at least one of one or more specific tasks or one or more operations;
retrieving (310), via the one or more hardware processors, a first set of data corresponding to the one or more queries specific to the problem formulation from a knowledge base, by interacting with the knowledge base using the one or more autonomous programs;
identifying (312), via the one or more hardware processors, missing data from the first set of data corresponding to the one or more queries specific to the problem formulation as one or more gaps;
retrieving (314), via the one or more hardware processors, a second set of data from one or more accessible resources based on the identified one or more gaps;
updating (316), via the one or more hardware processors, the knowledge base with the retrieved second set of data; and
iteratively performing (318), via the one or more hardware processors, the following steps until the one or more requirements specific to the design of the industrial entity from the user is satisfied:
(i) retrieving at least one of one or more process models and corresponding one or more optimization models based on the second set of data updated in the knowledge base;
(ii) selecting at least one relevant process model amongst the retrieved one or more process models based on the one or more queries specific to the problem formulation;
(iii) evaluating at least one of the retrieved one or more optimization models corresponding to the selected relevant process model;
(iv) selecting at least one relevant optimization model amongst the evaluated one or more optimization models; and
(v) obtaining feedback from the user based on the selection.

2. The processor implemented method as claimed in claim 1, wherein the design of the industrial entity comprises at least one of an engineering design or process design including at least one of a thermal design, a mechanical design, and a system design.

3. The processor implemented method as claimed in claim 1, wherein the one or more subproblem formulations comprise at least one of a design of the industrial entity and one or more operational constraints specific to the industrial entity.

4. The processor implemented method as claimed in claim 1, wherein the one or more resources comprise at least one of one or more articles, one or more web articles, one or more design manuals and a digital book.

5. A system (100), comprising:
a memory (104) storing instructions;
one or more communication interfaces (112); and
one or more hardware processors (102) coupled to the memory (104) via the one or more communication interfaces (112), wherein the one or more hardware processors (102) are configured by the instructions to:
obtain a first set of responses for a first set of questions from a user, wherein the first set of questions comprise one or more requirements specific to a design of an industrial entity;
generate a second set of questions using one or more Large Language Models (LLMs) by refining the first set of questions based on the first set of responses;
obtain a second set of responses for the second set of questions from the user;
generate, using one or more autonomous programs, one or more queries specific to a problem formulation comprising one or more sub problem formulations based on the second set of responses, wherein the one or more autonomous programs refer to one or more entities that perform at least one of one or more specific tasks or one or more operations;
retrieve a first set of data corresponding to the one or more queries specific to the problem formulation from a knowledge base, by interacting with the knowledge base using the one or more autonomous programs;
identify missing data from the first set of data corresponding to the one or more queries specific to the problem formulation as one or more gaps;
retrieve a second set of data from one or more accessible resources based on the identified one or more gaps;
update the knowledge base with the retrieved second set of data; and
iteratively perform the following steps until the one or more requirements specific to the design of the industrial entity from the user is satisfied:
(i) retrieving at least one of one or more process models and corresponding one or more optimization models based on the second set of data updated in the knowledge base;
(ii) selecting at least one relevant process model amongst the retrieved one or more process models based on the one or more queries specific to the problem formulation;
(iii) evaluating at least one of the retrieved one or more optimization models corresponding to the selected relevant process model;
(iv) selecting at least one relevant optimization model amongst the evaluated one or more optimization models; and
(v) obtaining feedback from the user based on the selection.

6. The system as claimed in claim 5, wherein the design of the industrial entity comprises at least one of an engineering design or process design including at least one of a thermal design, a mechanical design, and a system design.

7. The system as claimed in claim 5, wherein the one or more subproblem formulations comprise at least one of a design of the industrial entity and one or more operational constraints specific to the industrial entity.

8. The system as claimed in claim 5, wherein the one or more resources comprise at least one of one or more articles, one or more web articles, one or more design manuals and a digital book.

9. One or more non-transitory machine-readable information storage mediums comprising one or more instructions which when executed by one or more hardware processors cause:
obtaining a first set of responses for a first set of questions from a user, wherein the first set of questions comprise one or more requirements specific to a design of an industrial entity;
generating a second set of questions using one or more Large Language Models (LLMs) by refining the first set of questions based on the first set of responses;
obtaining a second set of responses for the second set of questions from the user;
generating, using one or more autonomous programs, one or more queries specific to a problem formulation comprising one or more sub problem formulations based on the second set of responses, wherein the one or more autonomous programs refer to one or more entities that perform at least one of one or more specific tasks or one or more operations;
retrieving a first set of data corresponding to the one or more queries specific to the problem formulation from a knowledge base, by interacting with the knowledge base using the one or more autonomous programs;
identifying missing data from the first set of data corresponding to the one or more queries specific to the problem formulation as one or more gaps;
retrieving a second set of data from one or more accessible resources based on the identified one or more gaps;
updating the knowledge base with the retrieved second set of data; and
iteratively performing, the following steps until the one or more requirements specific to the design of the industrial entity from the user is satisfied:
(i) retrieving at least one of one or more process models and corresponding one or more optimization models based on the second set of data updated in the knowledge base;
(ii) selecting at least one relevant process model amongst the retrieved one or more process models based on the one or more queries specific to the problem formulation;
(iii) evaluating at least one of the retrieved one or more optimization models corresponding to the selected relevant process model;
(iv) selecting at least one relevant optimization model amongst the evaluated one or more optimization models; and
(v) obtaining feedback from the user based on the selection.

10. The one or more non-transitory machine-readable information storage mediums as claimed in claim 9, wherein the design of the industrial entity comprises at least one of an engineering design or process design including at least one of a thermal design, a mechanical design, and a system design.

11. The one or more non-transitory machine-readable information storage mediums as claimed in claim 9, wherein the one or more subproblem formulations comprise at least one of a design of the industrial entity and one or more operational constraints specific to the industrial entity.

12. The one or more non-transitory machine-readable information storage mediums as claimed in claim 9, wherein the one or more resources comprise at least one of one or more articles, one or more web articles, one or more design manuals and a digital book.
